# EUROPEAN PATENT APPLICATION

(11) **EP 4 283 934 A1**
(43) Date of publication of application: **29.11.2023**
(21) Application number: 22175753.7
(22) Date of filing: 27.05.2022
(51) Int. Cl.: H04L 25/02, G01R 31/08, G01R 31/58

(54) **TRANSMITTER AND METHOD FOR THE TRANSMITTER**

(71) Applicant: NXP USA, Inc., Austin TX 78735 (US)
(72) Inventor: Boezen, Hendrik, 5656 AG Eindhoven (NL)
(74) Representative: Schmütz, Christian Klaus Johannes

(57) **Abstract**

The present invention relates to transmitter for transmitting a message to a receiver, wherein comprises a detector unit for monitoring the output signal of the transmitter and a control unit, which is configured to derive an average signal of selected section of the output signal and to detect a fault on a signal line between the transmitter and the receiver based on the average signal. The present invention also relates to a method for the transmitter.

## Description

### TECHNICAL FIELD

The present disclosure relates to transceiver for transmitting a message to a receiver. The present disclosure also relates to a method for the transceiver.

### BACKGROUND

By using differential signals for message transmission, messages can be transmitted from a transmitter to a receiver robust against disturbances. Instead of a single signal conductor, two similar signal conductors usually extend between the transmitter and the receiver. A first signal is transmitted on one of the two signal conductors and a complementary second signal is transmitted on the other signal conductor. The receiver can derive the message to be transmitted from the difference between the two signals.

As a result of their complementary nature, it can be assumed that both the first signal and the second signal each represent the message to be transmitted. If an error occurs in one of the two signal conductors, it is basically possible to transport the message to the receiver using only the other signal conductor and the signal that can be transmitted via this signal conductor. However, the transmission of the message via a single signal conductor can be affected by disturbances. In many applications, the transmission of messages must be robust against disturbances. Therefore, it would be useful to be able to determine as quickly as possible and without influencing the ongoing message transmission whether the transmission of messages from a transmitter to a receiver is robust against disturbances.

### SUMMARY

Aspects of the disclosure are defined in the accompanying claims.

In accordance with a first aspect of the present disclosure, a transmitter is provided for transmitting a message to a receiver. The transmitter comprising: a first signal generating unit having a first internal impedance and a first signal interface coupled to a first output terminal of the transmitter, a second signal generating unit having a second internal impedance and a second signal interface coupled to a second output terminal of the transmitter a control unit, and a first detector unit, wherein the first detector unit is coupled to the first output terminal, which can be coupled to the receiver via a first signal line, wherein the message comprises a plurality of symbols, each symbol comprising a first symbol part and a second symbol part, wherein the control unit is configured to control the first and second signal generating units for transmitting each first symbol part such that, for each first symbol part, a first internal voltage is generated by the first signal generating unit over a respective associated first time period and a second internal voltage is generated by the second signal generating unit over the same first time period, wherein a predefined first voltage difference is between the first internal voltage and the second internal voltage, wherein the first detector unit is configured to detect a first output signal at the first output terminal, wherein the control unit is configured to control the first detector unit such that the first detector unit detects the first output signal in each first time period as a respective first signal section, wherein the first detector unit is configured to generate a first average signal from the first signal sections, and wherein the control unit is configured to detect a first fault on the first signal line based on the first average signal.

In one or more embodiments, the control unit is configured to control the first and second signal generating units to transmit each second symbol part such that, for each second symbol part, the second internal voltage is generated by the first signal generating unit over a respective associated second time period and the first internal voltage is generated by the second signal generating unit over the same second time period, wherein the control unit is configured to control the first detector unit such that the first detector unit detects the first output signal in each second time period, respectively, as a second signal section, wherein the first detector unit is configured to generate a second average signal from the second signal sections, and wherein control unit is configured to detect the first fault on the first signal line based on the first average signal and the second average signal.

In one or more embodiments, the control unit is configured to detect the first fault on the first signal line based on a first difference between the first average signal and the second average signal.

In one or more embodiments, the control unit is configured to compare the first difference to a first reference value and, based on the comparison result, detect the first fault on the first signal line.

In one or more embodiments, the control unit is configured to detect the first fault on the first signal line as a short circuit between the first and second signal lines if the first difference is smaller than the first reference value by more than a first threshold value.

In one or more embodiments, the control unit is configured to detect the first fault on the first signal line as an open wire at the first signal line if the first difference is larger than the first reference value by more than the first threshold value.

In one or more embodiments, the transmitter comprises a second detector unit, wherein the second detector unit is coupled to the second output terminal, which can be coupled to the receiver via a second signal line, wherein the second detector unit is configured to detect a second output signal at the second output terminal, wherein the control unit is configured to control the second detector unit such that the second detector unit detects the second output signal in each first time period as a respective third signal section, wherein the second detector unit is configured to generate a third average signal from the third signal sections, and wherein the control unit is configured to detect a second fault on the second signal line based on the third average signal.

In one or more embodiments, the control unit is configured to control the first and second signal generating units to transmit each second symbol part such that, for each second symbol part, the second internal voltage is generated by the first signal generating unit over a respective associated second time period and the first internal voltage is generated by the second signal generating unit over the same second time period, wherein the control unit is configured to control the second detector unit such that the second detector unit detects the second output signal in each second time period, respectively, as a fourth signal section, wherein the second detector unit is configured to generate a fourth average signal from the fourth signal sections, and wherein control unit is configured to detect the second fault on the second signal line based on the third average signal and the fourth average signal.

In one or more embodiments, the control unit is configured to detect the second fault on the second signal line based on a second difference between the third average signal and the fourth average signal.

In one or more embodiments, the control unit is configured to compare the second difference to a second reference value and, based on the comparison result, detect the second fault on the second signal line.

In one or more embodiments, the control unit is configured to detect the second fault on the second signal line as a short circuit between the first and second signal line if the second difference is smaller than the second reference value by more than a second threshold value.

In one or more embodiments, the control unit is configured to detect the second fault on the second signal line as a short circuit from the second signal line to ground if the second difference is smaller than the second reference value by more than a third threshold value.

In one or more embodiments, the control unit is configured to detect the second fault on the second signal line as an open wire at the second signal line if the second difference is larger than the second reference value by more than the second threshold value.

In one or more embodiments, the control unit is configured to detect a third fault on the one of the signal lines based on the first average signal and the third average signal.

In one or more embodiments, the control unit is configured to detect a fourth fault on the one of the signal lines based on the second average signal and the fourth average signal.

In accordance with a second aspect of the present disclosure, a method is provided for a transmitter to transmit a message to a receiver, wherein the transmitter comprising a first signal generating unit with a first internal impedance and a first signal interface coupled to a first output terminal of the transmitter, the transmitter further comprising a second signal generating unit with a second internal impedance and a second signal interface coupled to a second output terminal of the transmitter, the transmitter further comprising a control unit and a first detector unit coupled to the first output terminal adapted to be coupled to the receiver via a first signal line, wherein the message comprises a plurality of symbols, each symbol comprising a first symbol part and second symbol part. The method comprises the steps a) to e):
a) controlling the first and second signal generating units with the control unit to transmit each first symbol part so that, for each first symbol part, a first internal voltage is generated by the first signal generating unit and a second internal voltage is generated by the second signal generating unit over a respective associated first time period, wherein a predefined first voltage difference is between the first internal voltage and the second internal voltage,
b) detecting a first output signal at the first output terminal via the first detector unit,
c) controlling the first detector unit by the control unit such that the first detector unit detects the first output signal in each first time period as a first signal section,
d) generating a first average signal from the first signal sections by the first detector unit, and
e) detecting a fault on the first signal line based on the first average signal by the control unit.

In accordance with a third aspect of the present disclosure, a computer program is provided, comprising executable instructions which, when executed by a processing unit, cause the processing unit being configured to carry out the method of the second aspect.

In accordance with a fourth aspect of the present disclosure, a system is provided, which comprises the transmitter according to the first aspect, a receiver and signal lines extending between the output terminals of the transmitter and input terminals of the receiver.

### DESCRIPTION OF DRAWINGS

Embodiments of the present disclosure will be described in more detail with reference to the appended drawings, in which:
Figures 1, 2 and 5 show a block diagrams of a system including a transmitter.
Figure 3A to 4E show simplified signals curves.
Fig. 6 shows a simplified flow chart of a method.

### DESCRIPTION OF EMBODIMENTS

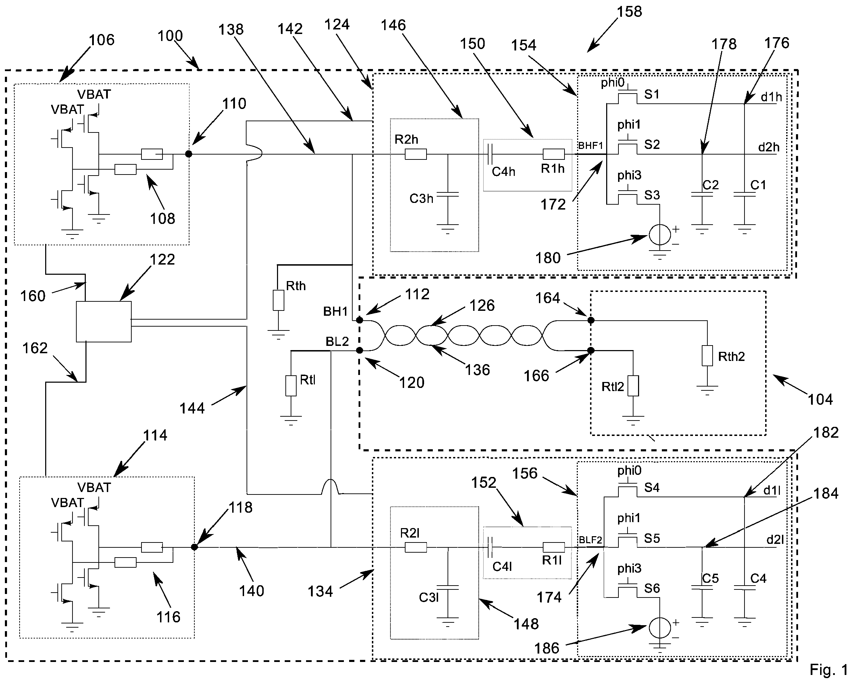

Figure 1 schematically illustrates one embodiment of a transmitter 100 according to the present disclosure. The transmitter 100 may be coupled to a receiver 104 via two signal lines 126, 136. Together, the transmitter 100, the signal lines 126, 136, and the receiver 104 may form a system 158. The system 158 may also be referred to as a communication system. The following explanations of the transmitter 100 may refer to a single transmitter 100 that is not part of the system 158, although the transmitter 100 may be used in the system 158 in principle. With this in mind, the following explanations of the transmitter 100 apply both to a single transmitter 100 that is separate from the system 158 and, by analogy, to a transmitter 100 that may form part of the system 158.

The transmitter 100 is used to transmit a message to the receiver 104. The message may be understood as a digital message. The message may therefore comprise a plurality of symbols, each representing one or more bits.

The transmitter 100 comprises two signal generating units 106, 114. Although the two signal generating units 106, 114 are schematically shown as separate units in Figure 1, the two signal generating units 106, 114 may be partially or fully integral. However, it is also possible that the two signal generating units 106, 114 are formed separately from each other in the transmitter 100.

The first signal generation unit 106 of the transmitter 100 comprises a first impedance 108 and a first signal interface 110. The first signal interface 110 is preferably not accessible from the outside, but is preferably configured as a node. The first impedance 108 may be formed by a plurality of impedance components, for example connected to each other in a star configuration. The impedance components may be interconnected in a common node and each lead to an associated separate voltage source, each comprising an inverter circuit for example.

The second signal generation unit 114 of the transmitter 100 comprises a second impedance 116 and a second signal interface 118. The second signal interface 118 is preferably not accessible from the outside, but is preferably configured as a node. The second impedance 116 may be formed by a plurality of impedance components, for example connected to each other in a star configuration. The impedance components may be interconnected in a common node and each lead to an associated separate voltage source, each comprising an inverter circuit for example.

The transmitter 100 includes a first output terminal 112 and a second output terminal 120. The first signal interface 110 of the first signal generating unit 106 is preferably connected to the first output terminal 112 of the transmitter 100 via a first internal signal connection 138. The second signal interface 118 of the second signal generating unit 114 is preferably connected a second internal signal connection 140 to the second output terminal 120 of the transmitter 100.

The transmitter 100 further comprises a control unit 122. Preferably, the control unit 122 is coupled to the first signal generating unit 106 via a first control signal connection 160 such that the first signal generating unit 106 is controllable by the control unit 122. It is further preferred that the control unit 122 is coupled to the second signal generating unit 114 via a second control signal connection 162, such that the second signal generating unit 114 is controllable by the control unit 122. The control unit 122 may be configured to control the first signal generating unit 106 and the second signal generating unit 114 so that an electrical differential voltage signal may be generated at the two output terminals that represents the symbols of the message, and thus the message to be transmitted. In an example, the control unit 122 may be configured to control the inverter circuits of the first signal generating unit 106 and the inverter circuits of the second signal generating unit 114 to generate the aforementioned electrical differential voltage signal. The control unit 122 may further include a signal input (not shown) to receive an input signal representing the message to be transmitted. The control unit 122 may be configured to control the first signal generating unit 106 and the second signal generating unit 114 based on the input signal and/or based on the message to be transmitted.

If the first signal line 126 and the second signal line 136 are not defective or otherwise adversely affected, the two signal lines 126, 136 may transmit a differential voltage signal from the output terminals 112, 120 to input terminals 164, 166 of the receiver 104. The first signal line 126 may extend from the first output terminal 112 of the transmitter 100 to the first input terminal 164 of the receiver 104. The second signal line 136 may extend from the second output terminal 120 of the transmitter 100 to the second input terminal 166 of the receiver 104.

If a fault occurs in either of the signal lines 126, 136, the transmission of the differential voltage signal from the output terminals 112, 120 to the input terminals 164, 166 is affected.

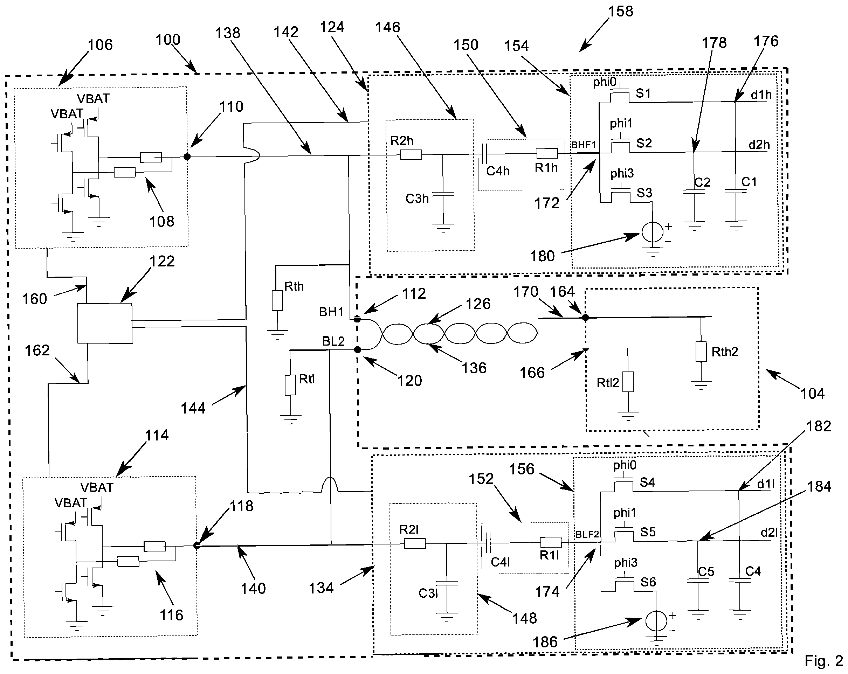

In Figure 2, the transmitter 100 and receiver 104 of Figure 1 are again shown schematically. However, unlike in Figure 1, one of the two signal lines 126, 136 in Figure 2 is affected by a fault. In an example the first signal line 126 has an open circuit, causing a fault. This fault may also be referred to as an open wire. As a result of the fault on the first signal line 126, the electrical signal generated at the first output terminal 112 is not transmitted, or at least not properly transmitted, to the first input terminal 164 of the receiver 104. The electrical signal generated at the second output terminal 120 may be transmitted to the second input terminal 166 of the receiver 104 via the fault-free, second signal line 136. It should be noted, however, that the electrical signal transmitted via the second signal line 136 may be affected and/or overlaid by disturbances. The fault on the first signal line 126 may therefore result in the transmission of the message from the transmitter 100 to the receiver 104 not being robust to disturbance. Therefore, there is a need to be able to determine whether a fault exists on the signal lines 126, 136.

The transmitter 100 comprises a first detector unit 124. The first detector unit 124 may also be referred to as the first detector 124. The first detector unit 124 is coupled to the first output terminal 112. In an example, the first signal connection 138 branches such that the first output terminal 112 of the transmitter 100, the first signal interface 110 of the first signal generation unit 106, and the first detector unit 124 are electrically connected. Therefore, a signal generated by the first signal generating unit 106 to transmit a message from the transmitter 100 to the receiver 104 can be directed to both the first output terminal 112 and the first detector unit 124 via the first internal signal connection 138.

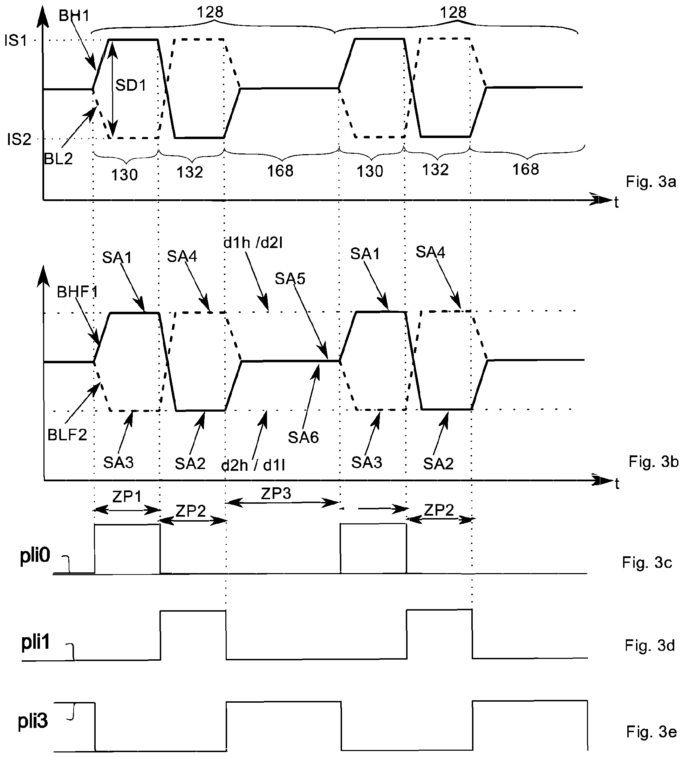

In an example, a first output signal BH1 is shown as a solid line in Figure 3a. In Figure 3a, a second output signal BL2 is also shown as a dashed line. The first output signal BH1 may be generated by the first signal generation unit 106 at the associated first signal interface 110. The second output signal BL2 may be generated by the second signal generation unit 114 at the associated second signal interface 118. Together, the first output signal BH1 and the second output signal BL2 form a differential output signal that can be generated by the transmitter 100 for transmission via the two output terminals 112, 120. Preferably, the first output signal BH1 and the second output signal BL2 are complementary.

The differential output signal may represent a message to be transmitted by the transmitter 100 that includes a plurality of symbols 128. In Figure 3a, two successive symbols 128 are represented by the differential output signal. Each symbol 128 has a first symbol portion 130 and a second symbol portion 132. Each symbol 128 may further have a third symbol portion 168. Each symbol 128 may be formed by the three symbol portions 130, 132, 168.

The control unit 122 is configured such that the control unit 122 controls the first and second signal generating units 106, 114 to transmit each first symbol portion 130 such that, for each first symbol portion 130, a first internal voltage IS1 is generated by the first signal generating unit 106 over a respective associated first time period ZP1 and a second internal voltage IS2 is generated by the second signal generating unit 114 over the same first time period ZP1. In an example, the control unit 122 controls the first signal generation unit 106 to transmit a first symbol portion 130 such that the first output signal BH1 generated by the first signal generation unit 106 at the associated first signal interface 110 initially ramps up during the associated first time period ZP1 and then maintains the first internal voltage IS1 continuously for a certain time during the first time period ZP1. Preferably, the first internal voltage IS1 is continuously present for at least 80% of the first time period ZP1. For transmitting the same first symbol portion 130, the control unit 122 in the example controls the second signal generating unit 114 to transmit this first symbol portion 130 such that the second output signal BL2 generated by the second signal generating unit 114 at the associated second signal interface 118 first ramps down during the associated first time period ZP1 and then continuously holds the second internal voltage IS2 for the certain time during the first time period ZP1. Preferably, the second internal voltage IS2 is continuously present for at least 80% of the first time period ZP1. A predefined first voltage difference SD1 exists between the first internal voltage IS1 and the second internal voltage IS2.

In an example, the control unit 122 is further configured such that the control unit 122 controls the first and second signal generating units 106, 114 to transmit each second symbol portion 132 such that, for each second symbol portion 132, the second internal voltage IS2 is generated by the first signal generating unit 106 over an associated second time period ZP2 and the first internal voltage IS1 is generated by the second signal generating unit 114 over the same second time period ZP2. In an example, the control unit 122 controls the first signal generating unit 106 to transmit a second symbol portion 132 such that the first output signal BH1 generated by the first signal generating unit 106 at the associated first signal interface 110 first ramps down during the associated second time period ZP2 and then maintains the second internal voltage IS2 continuously for a certain time during the first time period ZP2. Preferably, the second internal voltage IS2 is continuously present for at least 80% of the second time period ZP2. For transmitting the same second symbol portion 132, the control unit 122 in the example controls the second signal generating unit 114 to transmit this second symbol portion 132 such that the second output signal BL2 generated by the second signal generating unit 114 at the associated second signal interface 118 first ramps up during the associated second time period ZP2 and then continuously holds the first internal voltage IS1 for the certain time during the first time period ZP2. Preferably, the first internal voltage IS1 is continuously present for at least 80% of the second time period ZP2. The predefined first voltage difference SD1 exists between the first internal voltage IS1 and the second internal voltage IS2. As a result, the first internal voltage IS1 and the second internal voltage IS2 differ by the predefined first voltage difference SD1. The first voltage difference SD1 may be understood as an amount of voltage that exists between the first and second voltage, or vice versa. As a further result, the predefined first voltage difference exists between the first internal voltage SD1 and the second internal voltage SD2, or vice versa.

In an example, the first internal voltage is between 4V and 10V, and the second internal voltage is between 1V and 4V. In another example, the first voltage difference is between 3V and 8V.

In an example, the control unit 122 is further configured such that the control unit 122 controls the first and second signal generation units 106, 114 to transmit each third symbol portion 168 such that for each third symbol portion 168, the same third internal voltage is generated by the first signal generation unit 106 over an associated time period ZP3 and by the second signal generation unit 114 over the same time period ZP3. The third internal voltage is preferably the average of the first internal voltage IS 1 and the second internal voltage IS2.

Since the first detector unit 124 is coupled to the first output terminal 112, the first output signal BH1 may be transmitted to the first detector unit 124. The first detector unit 124 is configured such that the first detector unit 124 detects the first output signal BH1 at the first output terminal 112.

The first detector unit 124 may include a first low-pass filter unit 146, a first DC component suppression unit 150, and a first sampling unit 154. The first low-pass filter unit 146 may be configured to filter the first output signal BH1 with a low-pass function. The low-pass filter unit 146 may be configured to suppress or remove frequency components whose frequency is greater than the highest frequency of the first signal generating unit 106. The signal filtered accordingly by the first low-pass filter unit 146 may be directed to the first DC component suppression unit 150, in which the DC component is suppressed or reduced. Based on the first output signal BH1 of Figure 3a, the first measurement signal BHF1, which is shown as a solid line in Figure 3b, can be generated at the output of the DC component suppression unit 150.

The control unit 122 is configured such that the control unit 122 controls the first detector unit 124 such that the first detector unit 124 detects the first output signal BH1 in each first time period ZP1 as a respective first signal portion SA1. This results in the detection of a plurality of first signal section SA1. Each first signal section SA1 represents at least a portion of the first output signal BH1 during the associated first time period ZP1. In an example, each first signal portion SA1 may represent the portion of the first output signal BH1 during the associated first time period ZP1 in which the first output signal BH1 has a continuous voltage level. Further, each first signal portion SA1 may represent the portion of the first output signal BH1 during the associated first time period ZP1 without requiring the first signal portion SA1 to be identical to the represented portion of the first output signal BH1. In an example, the first signal portion SA1 may qualitatively represent the corresponding portion of the first output signal BH1. This may be caused, for example, by the first low-pass filter unit 146 and/or by the first DC component suppression unit 150. In an example, each first signal portion SA1 may represent a signal filtered portion of the first output signal BH1 during the corresponding first time period ZP1.

In an example, the first sampling unit 154 comprises a first series circuit extending from an input node 172 of the first sampling unit 154 to a reference potential, in particular ground potential. The first series circuit comprises a first switch unit S1 and a first capacitor C1. In an example, the control unit 122 is coupled to the first switch unit S1 via the third control signal line 142 so that the control unit 122 can control the first switch unit S1. Figure 3c illustrates an example of a control signal phi0 that can be generated by the control unit 122 to control the first switch unit S1. Preferably, the control signal phi0 is such that the switch unit S1 is closed during each first time period ZP1. Furthermore, the control signal phi0 is preferably configured such that the first switch unit S1 is open during the remaining time period. In an example, the control signal phi0 may therefore be transmitted from the control unit 122 to the switch unit S1 such that the first switch unit S1 is closed exclusively during each first time period ZP1. In each first time period ZP1, the capacitor C1 is charged by the portion of the first measurement signal BHF1 that is applied during the respective first time period ZP1. As a result, the capacitor C1 is charged exclusively in each first time period ZP1 by a first signal portion SA1. The capacitor C1 is not charged during the other time periods. Therefore, the voltage across the capacitor C1 represents an average of the voltages of the first signal sections SA1 that have contributed to the charging of the capacitor C1. A first average signal d1h representing an average of the voltage values from the first signal sections SA1 may therefore be taken at a node 176 of the first series circuit between the first switch S1 and the capacitor C1 . The first detector unit 124 is therefore configured such that the first detector unit 124 generates a first average signal d1h from the first signal sections SA1. For this purpose, the first sampling unit 154 may be used. However, in principle, it is also possible for the first detector unit 124 to comprise another unit or another embodiment to generate the first average signal d1h from the first signal sections SA1.

Provided that the first signal line 126, which may extend from the first output terminal 112 of the transmitter to the first input terminal 164 of the receiver 104, is without fault, the first average signal d1h will represent an expectable and/or predictable voltage value. In Figure 3b, this voltage value is therefore represented by a dashed line representing a constant voltage level. However, should a fault occur in the first signal line 126, for example an interruption 170 of the first signal line 126, then this will have an impact on the first average signal d1h. The interruption 170 may also be referred to as a line break or open wire.

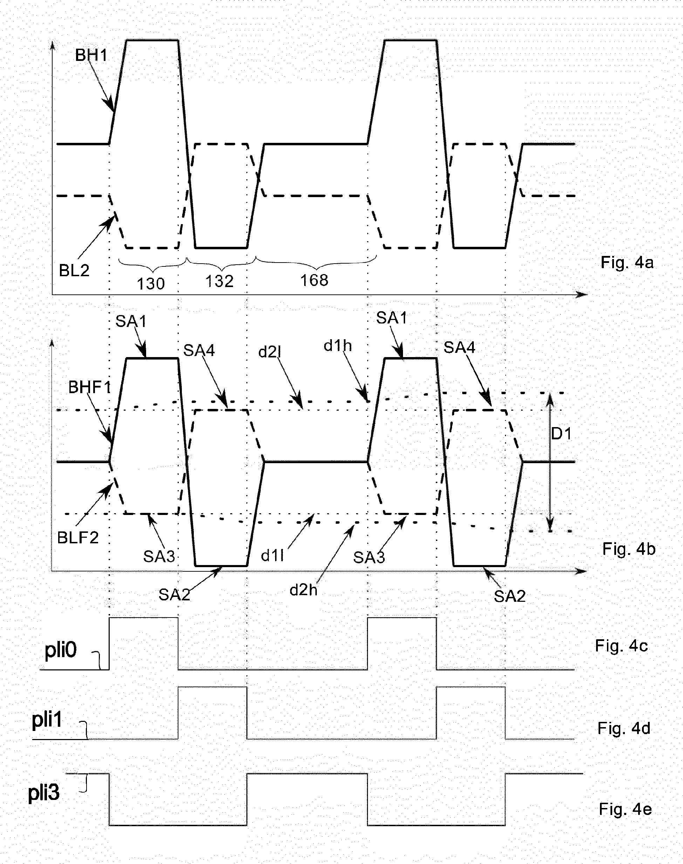

Preferably, the receiver 104 comprises a first impedance Rth2 acting between the first input terminal 164 and a reference potential, in particular a ground potential. If the interruption 170 exists in the first signal line 126, this first impedance Rth2 no longer acts indirectly on the first output terminal 112. It follows that the first signal generation unit 106 generates a first output signal BH1 with a larger voltage swing and a first measurement signal BHF1 with a larger voltage swing, while being driven by the control unit 122. The larger first output signal BH1 is shown in an example in Figure 4a. The resulting larger first measurement signal BHF1 is shown in Figure 4b. The control signal phi0 for controlling the first switch unit S1 remains unchanged, and is again shown in Figure 4c. Due to the larger voltage swing of the first measurement signal BHF1, the first switch unit S1 closed during the first time period SP1 will lead to a larger charge of the first capacitor C1, so that the voltage across the first capacitor C1 will increase with each time period ZP1 or with each first signal section SA1. This effect can also be seen in Figure 4b. The voltage value of the first average signal d1h increases exclusively during each first time period ZP1 or exclusively with each first signal section SA1. Therefore, from the increase in the voltage value of the first average signal dlh, it can be inferred that there is an interruption 170 in the first signal line 126.

The control unit 122 is therefore configured to detect a first fault, such as an interruption 170, on the first signal line 126 based on the first average signal d1h. In an example, the node 176 is coupled to the control unit 122 (not shown). The control unit 122 may be configured to evaluate the first average signal d1h. Further, the control unit 122 may be configured to determine whether the first fault exists on the first signal line 126 based on the result of the evaluation.

The detection of the first fault on the first signal line 126 does not affect the transmission of a message from the transmitter 100 to the receiver 104. The control unit 122 of the transmitter 100 and the first detector unit 124 of the transmitter 100 allow the detection of the first fault during regular operation without requiring an interruption of the message transmission. Furthermore, the detection of the first fault on the first signal line 126 by means of the transmitter 100 according to the present disclosure does not depend on a possible test message to be sent first from the transmitter 100 to the receiver 104 and subsequently from the receiver 104 back to the transmitter 100. Such an exchange of a test message causes a time delay, which is to be avoided in time-critical systems or in systems with a particularly high requirement for robust message transmission. Detection of the first fault on the first signal line 126 by means of the transmitter 100 according to the present disclosure does not cause the aforementioned time delay. The detection of a first fault on the first signal line 126 by means of the transmitter 100 according to the present disclosure can therefore be performed particularly quickly and at the same time without disturbing the regular message transmission.

In an example, the control unit 122 may be configured such that the control signal phi0 is configured such that the control unit closes the first switch unit S1 with the control signal phi0 exclusively in a time section during the first time period ZP1 that is between the end of the rising ramp of the first signal section SA1 and the beginning of the falling ramp of the first signal section SA1.

The transmitter 100 may form part of a transceiver (not shown).

It is also preferred that the first voltage difference SD1 is greater than 0.

Furthermore, it is noted that the control unit 122 uses the first average signal d1h to detect the first fault on the first signal line 126, without excluding that other signals, reference values and/or determinations are made by the control unit 122, on the basis of which the detection of the first fault may be additionally based.

Although the preceding explanations have partially referred to the first output signal BH1 shown in Figure 3a, it should be noted that the first output signal BH1 may have a different waveform. For example, the waveforms of the first output signal BH1 and the second output signal BL2 may be interchanged without affecting the functionality of the first detector unit 124 and the control unit 122. The fault on the first signal line 126 may continue to become detected.

As previously discussed, in an example, the control unit 122 is further configured such that the control unit 122 controls the first and second signal generating units 106, 114 to transmit each second symbol portion 132 such that, for each second symbol portion 132, the second internal voltage IS2 is generated by the first signal generating unit 106 over an associated second time period ZP2 and the first internal voltage IS1 is generated by the second signal generating unit 114 over the same second time period ZP2.

In an example, the control unit 122 controls the first signal generating unit 106 to transmit a second symbol portion 132 such that the first output signal BH1 generated by the first signal generating unit 106 at the associated first signal interface 110 first ramps up down during the associated second time period ZP2 and then maintains the second internal voltage IS2 continuously for a certain of time during the second time period ZP2. Preferably, the second internal voltage IS2 is continuously present for at least 80% of the second time period ZP2. For transmitting the same second symbol portion 132, the control unit 122 in the example controls the second signal generating unit 114 to transmit this second symbol portion 132 such that the second output signal BL2 generated by the second signal generating unit 114 at the associated second signal interface 118 first ramps up during the associated second time period ZP2 and then continuously holds the first internal voltage IS 1 for the certain time. Preferably, the first internal voltage IS1 is continuously present for at least 80% of the second time period ZP2. The predefined first voltage difference SD1 exists between the first internal voltage IS1 and the second internal voltage IS2.

In an example, the control unit 122 is configured such that the control unit 122 controls the first detector unit 124 such that the first detector unit 124 detects the first output signal BH1 in each second time period ZP2 as a respective second signal portion SA2. This results in the detection of a plurality of first second section SA2. Each second signal section SA2 represents at least a portion of the first output signal BH1 during the associated second time period ZP2. In an example, each second signal portion SA2 may represent the portion of the first output signal BH1 during the associated second time period ZP2 in which the first output signal BH1 has a continuous voltage level. Further, each second signal portion SA2 may represent the portion of the first output signal BH1 during the associated first time period ZP2 without requiring the second signal portion SA2 to be identical to the represented portion of the first output signal BH1. In an example, the second signal portion SA2 may qualitatively represent the corresponding portion of the first output signal BH1. This may be caused, for example, by the first low-pass filter unit 146 and/or by the first DC component suppression unit 150. In an example, each second signal portion SA2 may represent a signal filtered portion of the first output signal BH1 during the corresponding second time period ZP2.

In an example, the first sampling unit 154 comprises a second series circuit extending from the input node 172 of the first sampling unit 154 to a reference potential, in particular the ground potential. The second series circuit comprises a second switch unit S2 and a second capacitor C2. In an example, the control unit 122 is coupled to the second switch unit S2 via the third control signal line 142 so that the control unit 122 can control the second switch unit S2. Figure 3d illustrates an example of a control signal phi1 that can be generated by the control unit 122 to control the second switch unit S2. Preferably, the control signal phi1 is such that the second switch unit S2 is closed during every second time period ZP2. Furthermore, the control signal phi1 is preferably configured such that the second switch unit S2 is open during the remaining time period. In an example, the control signal phi1 may therefore be transmitted from the control unit 122 to the second switch unit S2 such that the second switch unit S2 is closed exclusively during each second time period ZP2. During each second time period ZP2, the second capacitor C2 is charged by the portion of the first measurement signal BHF1 that is applied during the respective second time period ZP2. As a result, the second capacitor C2 is charged exclusively in each second time period ZP2 by a second signal portion SA2. During the remaining times, the second capacitor C2 is not charged. Therefore, the voltage across the second capacitor C2 represents an average of the voltages of the second signal sections SA2 that have contributed to the charging of the second capacitor C2. A second average signal d2h representing an average of the voltage values from the second signal sections SA2 may therefore be taken at a node 178 of the second series circuit between the second switch S2 and the second capacitor C2. The first detector unit 124 is therefore configured such that the first detector unit 124 generates a second average signal d2h from the second signal sections SA2. For this purpose, the first sampling unit 154 may be used. However, it is also possible in principle for the first detector unit 124 to comprise another unit or another embodiment to generate the second average signal d2h from the second signal sections SA2.

Provided that the first signal line 126, which may extend from the first output terminal 112 of the transmitter to the first input terminal 164 of the receiver 104, is without fault, the second average signal d2h will represent an expectable and/or predictable voltage value. In Figure 3b, this voltage value is therefore represented by a dashed line representing a constant voltage level.

However, should a fault occur in the first signal line 126, for example an interruption 170 of the first signal line 126, then this will affect the second average signal d2h.

As previously explained, the receiver 104 preferably has an impedance Rth2 that can act between the first input terminal 164 and a reference potential, in particular a ground potential. If the interruption 170 exists in the first signal line 126, this impedance Rth2 no longer acts indirectly on the first output terminal 112. It follows that the first signal generation unit 106 generates a first output signal BH1 with a larger voltage swing and a first measurement signal BHF1 with a larger voltage swing, while being driven by the control unit 122. The first output signal BH1 with the larger voltage swing is shown in an example in Figure 4a. From Figure 4a it can also be seen in an example that the lowest voltage may remain unchanged during the second time period ZP2, while the highest voltage increases significantly during the first time period ZP1. This effect may occur if the first signal generation unit 106 is coupled to a floating ground. To counteract this effect, the first sampling unit 154 may comprise a third series circuit extending from the input node 172 of the first sampling unit 154 to a reference potential, in particular the ground potential. The third series circuit includes a third switch unit S3 and a reference voltage source 180. In an example, the control unit 122 is coupled to the third switch unit S3 via the third control signal line 142 so that the control unit 122 can control the third switch unit S3. Figure 3e shows an example of the control signal phi3 that allows the control unit 122 to control the third switch unit S3. Preferably, the control signal phi3 is such that the third switch unit S3 is closed during every third time period ZP3. Furthermore, the control signal phi3 is preferably configured such that the third switch unit S3 is open during the remaining time, preferably corresponding to the combination of the first and second time period ZP1 and ZP2. Preferably, the second time period ZP2 follows the first time period ZP1. Furthermore, the third time period ZP3 preferably follows the second time period ZP2. The third time period ZP3 is preferably followed by the first time period ZP1 again. In an example, the control signal phi3 may be transmitted from the control unit 122 to the third switch unit S3 such that the third switch unit S3 is closed exclusively during each third time period ZP3. In each third time period ZP3, preferably both, the first and second switch unit S1 and S2, are open. In each third time period ZP3, the average value of the first measurement signal BHF1 is drawn to a voltage generated by the reference voltage source 180. As a result, the voltage swing of the first measurement signal BHF1 settles symmetrically around the average value of the first measurement signal BHF1. The correspondingly adjusted measurement signal BHF1 is shown in an example in Figure 3b.

The control signal phi1 for controlling the second switch unit S2 is again shown in Figure 4d. Due to the larger voltage swing of the first measurement signal BHF1 during the first fault in the first signal line 126, the second switch unit S2 being closed during the second time period SP2 will lead to a smaller charge of the second capacitor C2, so that the voltage applied across the second capacitor C2 decreases with every second time period ZP2 or with every second signal section SA2. This effect can also be seen in Figure 4b. The voltage value of the second average signal d2h decreases exclusively during every second time period ZP2 or exclusively with every second signal section SA2. From this decrease in the voltage value of the second average signal d2h, it can therefore also be inferred that there is an interruption 170 in the first signal line 126.

However, the interruption 170 in the first signal line 126 in the aforementioned example may also be derived from the difference between the voltage value of the first average signal d1h and the voltage value of the second average signal d2h. This is because, with the interruption 170 of the first signal line 126, the difference D1 between the first average signal d1h and the second average signal d2h increases significantly. The difference D1 is dependent on and/or even proportional to the electrical impedance, in particular the electrical resistance, experienced or seen by the transmitter 100 between the output terminals 112, 120 through the signal lines 126, 136 and the internal impedances, in particular internal resistances of the receiver 104. If an interruption 170 occurs as a fault in the first signal line 126, said impedance increases, so that the difference D1 also increases. If a short circuit occurs as a fault between the signal lines 126, 136, the impedance decreases and consequently the difference D1 decreases.

The control unit 122 is therefore configured to detect the first fault on the first signal line 126 based on the first average signal d1h and the second average signal d2h. In an example, the node 178 is coupled to the control unit 122 (not shown). The control unit 122 may be configured to evaluate the first average signal d1h and the second average signal d2h. Further, the control unit 122 may be configured to determine whether the first fault exists on the first signal line 126 based on the result of the evaluation.

In an example, the control unit 122 is configured to detect the first fault on the first signal line 126 based on the first difference D1 between the first average signal d1h and the second average signal d2h. Preferably, the first difference D1 refers to the actual difference between the actual value of the first average signal d1h and the actual value of the second average signal d2h.

As previously explained, the first difference D1 changes if a fault occurs in the first signal line 126. For example, if the fault is an interruption in the first signal line 126, as shown schematically in Figure 2, such that the receiver 104 effectively cannot act between the output terminals 112, 120 of the transmitter 100, the first difference D1 will increase as the interruption occurs. This effect can also be seen from Figs 4a and 4b.

If another fault occurs in the first signal line 126, for example, a short circuit occurs between the first signal line 126 and the second signal line 136 as a fault such that the receiver 104 also does not effectively operate between the output terminals 112, 120 of the transmitter 100, this fault may cause the first difference D1 to decrease as the short circuit occurs. The control unit 122 may be configured to determine and/or monitor the first difference D1. If a change in the first difference D1 occurs, the control unit 122 will be able to detect the change and based on the magnitude of the change and/or based on a value of the change per unit time, the control unit 122 may detect the fault in the first signal line 126. The determination and/or monitoring of the first difference D1 by the control unit 122 does not adversely affect the operation of the transmission of messages from the transmitter 100 to the receiver 104, and the determination and/or monitoring of the first difference D1 may be performed by the control unit 122 without delaying the transmission of the messages or affecting the content of the message transmission.

In an example, the control unit 122 is configured to compare the first difference D1 to a first reference value. The first reference value may be a predefined value. For example, the reference value may be detected during fault-free operation. For example, if it is ensured that there are no faults in the first signal line 126 and the second signal line 136, one or more messages may be transmitted to the receiver 104 by means of the transmitter 100, wherein the difference between the first average signal d1h and the second average signal d2h may be used by the control unit 1122 to determine the first reference value. Thus, the first reference value may be determined in an fault-free operation. This reference value may be stored by the control unit 122. In further operation of the transmitter 100, the control unit 122 may use the stored first reference value to compare the currently determined first difference D1 with the first reference value. In an example, the control unit 122 is configured to detect the first fault in the first signal line 126 based on the comparison result. For example, if the control unit 122 determines that the first difference is (significantly) larger or (significantly) smaller than the first reference value, the corresponding deviation may indicate a fault in the first signal line 126.

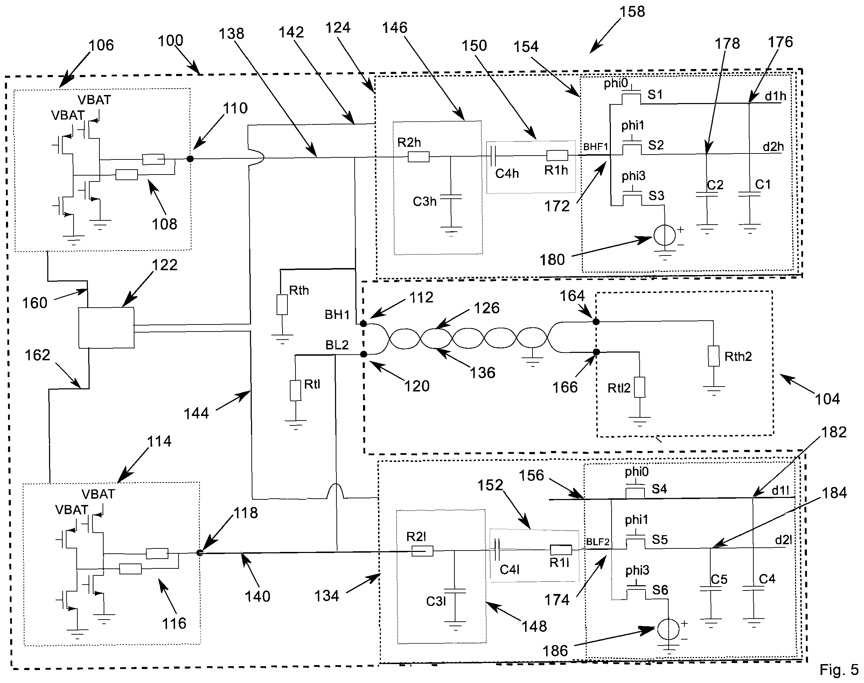

In Figure 5, the system 158 of Figure 1 is shown again, but with the difference that there is a short circuit between the first signal line 126 and the second signal line 136. In an example, the control unit 122 is configured to detect the first fault in the first signal line 126 as a short circuit between the first signal line 126 and the second signal line 136 if the first difference D1 is less than the first reference value by more than a first threshold value. As previously explained, the value of the first difference D1 decreases if a short circuit occurs between the first signal line 126 and the second signal line 136. Thus, if the first difference D1 is less than the first reference value, it indicates a short circuit between the first and second signal lines 126, 136. The first threshold value may be a predefined value. Furthermore, the first threshold value may be stored by the control unit 122. The first threshold value prevents small changes in the first difference D1, caused for example by noise, from leading to false positive fault detection. The first threshold value therefore helps to ensure that the first fault can be detected by means of the transmitter 100 in a manner that is robust to disturbance.

Furthermore, it was found that the first difference becomes smaller if, for example, the first signal line 126 receives a short circuit to a reference potential, such as the ground potential. For example, if the first signal line 126 is coupled to the ground potential, the electrical voltage on the first signal line 126 decreases, resulting in a decrease in the first difference D1. In an example, the control unit 122 is therefore configured to detect the first fault in the first signal line 126 as a short circuit between the first signal line 126 and a reference potential, in particular a ground potential, if the first difference D1 is less than the first reference value by more than a second threshold value. The second threshold value may be a predefined value. Preferably, the second threshold value is greater than the first threshold value. This makes it possible to distinguish whether there is a short circuit between the two signal lines 126, 136 or a short circuit of the first signal line 126 to the reference potential, in particular the ground potential.

In an example, the control unit 122 is configured to detect the first fault in the first signal line 126 as an interruption 170 of the first signal line 126 if the first difference D1 is greater than the first threshold value by more than the first reference value. The interruption may also be referred to as an open wire. As previously explained, the first difference D1 becomes larger if an interruption occurs in the first signal line 126. This is because in this case a smaller impedance acts between the output terminals 112, 120 of the transmitter. The first threshold value prevents small changes in the first difference D1, caused for example by disturbances, from leading to false positive fault detection. The first threshold value therefore helps to ensure that an interruption in the first signal line 126 as the first fault can also be robustly detected by means of the transmitter 100 in the face of disturbance.

In an example, the control unit 122 is configured to detect a first trajectory of the first difference over time and a first change per unit time in the first trajectory. Further, the control unit 122 may be configured to compare the first change per unit time with a first deviation value. The first deviation value may be a predefined value. The control unit 122 may be configured to detect the first fault in the first signal line 126 based on the result of the comparison. In an example, the control unit 122 may be configured to detect the first fault in the first signal line 126 if the value of the first change per unit time is greater than the first deviation value. If the change in the first difference D1 per unit time is greater than the first deviation value, it may be assumed that there is an unusually rapid change in the first difference D1 and such change is caused by a fault in the first signal line 126. Preferably, the time unit is at least 10ms so that high frequency noise can be prevented from causing a false positive fault detection. Furthermore, the time unit is preferably less than 500ms to ensure fast fault detection.

In an example, the control unit 122 is configured to detect a first duration while the first change per unit time is continuously greater than the first deviation value, and wherein the control unit 122 is preferably configured to detect the first fault in the first signal line based on the first duration. In an example, the first fault in the first signal line 126 is positively detected by the control unit 122 only if the first duration is greater than a predefined first time. Short very large changes in the first difference D1, such as may be caused by disturbance, are thus not considered faults.

In an example, the transmitter 100 includes a second detector unit 134. The second detector unit 134 may also be referred to as a second detector. The second detector unit 134 is coupled to the second output terminal 120. In an example, the second signal connection 140 branches such that the second output terminal 120 of the transmitter 100, the second signal interface 118 of the second signal generation unit 114, and the second detector unit 134 are electrically connected. Therefore, a signal generated by the second signal generating unit 114 to transmit a message from the transmitter 100 to the receiver 104 can be directed to both the second output terminal 120 and the second detector unit 134 via the second internal signal connection 140.

In an example, because the second detector unit 134 is coupled to the second output terminal 118, the second output signal BL2 may be transmitted to the second detector unit 134. Preferably, the second detector unit 134 is configured such that the second detector unit 134 detects the second output signal BL2 at the second output terminal 120.

In an example, the second detector unit 134 is analogous to the first detector unit 124. For the second detector unit 134, reference is therefore made to the advantageous explanation, preferred features, technical effects and advantages in an analogous manner as previously explained for the first detector 124.

In an example, the control unit 122 may be configured to control the second detector unit 134 in an analogous manner as the first detector unit 124. Therefore, for control, evaluation and/or fault detection in connection with the second detector unit 124, reference is made to the advantageous explanation, preferred features, technical effects and benefits in an analogous manner for the control unit 122 as explained for control, evaluation and/or fault detection in connection with the first detector unit 124.

The second detector unit 134 may include a second low-pass filter unit 148, a second DC component suppression unit 152, and a second sampling unit 156. The second low-pass filter unit 148 may be configured to filter the second output signal BL2 with a low-pass function. The second low-pass filter unit 148 may be configured to suppress or remove frequency components whose frequency is greater than the highest frequency of the second signal generation unit 114. The signal filtered accordingly by the second low-pass filter unit 148 may be directed to the second DC component suppression unit 152, in which the DC component is suppressed or reduced. Based on the second output signal BL2 of Figure 3a, the second measurement signal BLF2 shown as a dashed line in Figure 3b may be provided at the output of the second DC component suppression unit 152.

In an example, the control unit 122 is configured such that the control unit 122 controls the second detector unit 134 such that the second detector unit 134 detects the second output signal BL2 in each first time period ZP1 as a respective third signal portion SA3. This results in the detection of a plurality of third signal section SA3. Each third signal section SA3 represents at least a portion of the second output signal BL2 during the associated first time period ZP1. In an example, each third signal portion SA3 may represent the portion of the second output signal BL2 during the associated first time period ZP1 in which the second output signal BL2 has a continuous voltage level. Further, each third signal portion SA3 may represent the portion of the second output signal BL2 during the associated first time period ZP1 without requiring the third signal portion SA3 to be identical to the represented portion of the second output signal BL2. In an example, the third signal portion SA3 may qualitatively represent the corresponding portion of the second output signal BL2. This may be caused, for example, by the second low-pass filter unit 148 and/or by the second DC component suppression unit 152. In an example, each third signal portion SA3 may represent a signal filtered portion of the second output signal BL2 during the corresponding first time period ZP1.

In an example, the second sampling unit 156 comprises a fourth series circuit extending from a second input node 174 of the second sampling unit 156 to a reference potential, in particular ground potential. The fourth series circuit comprises a fourth switch unit S4 and a fourth capacitor C4. In an example, the control unit 122 is coupled to the fourth switch unit S4 via the fourth control signal line 144 so that the control unit 122 can control the fourth switch unit S4. Referring to Figure 3c, an example of a control signal phi0 that the control unit 122 can use to control the fourth switch unit S4 is shown. Preferably, the control signal phi0 is such that the fourth switch unit S4 is closed during each first time period ZP1. Furthermore, the control signal phi0 is preferably configured such that the fourth switch unit S4 is open during the remaining time period. In an example, the control signal phi0 may therefore be transmitted from the control unit 122 to the fourth switch unit S4 such that the fourth switch unit S4 is closed exclusively during each first time period ZP1. In each first time period ZP1, the fourth capacitor C4 is charged by the portion of the second measurement signal BLF2 that is applied during the respective first time period ZP1. As a result, the fourth capacitor C4 is charged exclusively in each first time period ZP1 by a third signal portion SA3. In the other time periods, the fourth capacitor C4 is not charged. Therefore, the voltage across the fourth capacitor C4 represents an average of the voltages of the third signal sections SA3 that contributed to the charging of the fourth capacitor C4. Therefore, at a node 182 of the fourth series circuit between the fourth switch S4 and the fourth capacitor C4, a third average signal d1l representing an average of the voltage values from the third signal sections SA3 can be taken. Therefore, the second detector unit 134 is configured such that the second detector unit 134 generates a third average signal d1l from the third signal sections SA3. For this purpose, the second sampling unit 156 may be used. However, in principle, it is also possible that the second detector unit 134 comprises another unit or another embodiment to generate the second average signal d1l from the third signal sections SA3.

Provided that the second signal line 136, which may extend from the second output terminal 120 of the transmitter 100 to the second input terminal 166 of the receiver 104, is without fault, the second average signal d1l will represent an expectable and/or predictable voltage value. In Figure 3b, this voltage value is therefore represented by a dashed line representing a constant voltage level. However, should a fault occur in the second signal line 136, for example an interruption (not shown) in the second signal line 136, then this will have an effect on the second average signal d1l. In this regard, reference will be made in an analogous manner to the discussion of the potential interruption 170 in the first signal line 126 and its effect on the first average signal d1h.

The control unit 122 is therefore configured to detect a second fault, such as an interruption in the second signal line 136 based on the second average signal d1l. In an example, the node 182 is coupled to the control unit 122 (not shown). The control unit 122 may be configured to evaluate the second average signal d1l. Further, the control unit 122 may be configured to determine whether the second fault exists on the second signal line 136 based on the result of the evaluation.

Detection of the second fault on the second signal line 136 does not affect transmission of a message from the transmitter 100 to the receiver 104. The control unit 122 of the transmitter 100 and the second detector unit 134 of the transmitter 100 allow detection of the second fault during regular operation without requiring interruption of message transmission.

In an example, the control unit 122 may be configured such that the control signal phi0 is configured such that the control unit 122 closes the fourth switch unit S4 with the control signal phi0 exclusively in a certain time during the first time period ZP1 that is between the end of the falling ramp of the third signal section SA3 and the beginning of the rising ramp of the third signal section SA3.

Furthermore, it is noted that the control unit 122 uses the second average signal d1l to detect the second fault on the second signal line 136, without excluding that other signals, reference values and/or determinations are made by the control unit 122, on the basis of which the detection of the second fault may be additionally based.

In an example, the control unit 122 controls the second signal generating unit 114 to transmit a second symbol portion 132 such that the second output signal BL2 generated by the second signal generating unit 114 at the associated first signal interface 118 first ramps up during the associated second time period ZP2 and then maintains the first internal voltage IS1 continuously for a certain time during the second time period ZP2. Preferably, the first internal voltage IS1 is continuously present for at least 80% of the second time period ZP2. For transmitting the same second symbol portion 132, the control unit 122 in the example controls the first signal generating unit 106 to transmit this second symbol portion 132 such that the first output signal BH1 generated by the first signal generating unit 106 at the associated first signal interface 110 first ramps down during the associated second time period ZP2 and then continuously holds the second internal voltage IS2 for the certain time during the second time period ZP2. Preferably, the second internal voltage IS2 is continuously present for at least 80% of the second time period ZP2. The predefined first voltage difference SD1 exists between the first internal voltage IS1 and the second internal voltage IS2.

In an example, the control unit 122 is configured such that the control unit 122 controls the second detector unit 134 such that the second detector unit 134 detects the second output signal BL2 in each second time period ZP2 as a respective fourth signal portion SA4. This results in the detection of a plurality of fourth signal section SA4. Each fourth signal section SA4 represents at least a portion of the second output signal BL2 during the associated second time period ZP2. In an example, each fourth signal portion SA4 may represent the portion of the second output signal BL2 during the associated second time period ZP2 in which the second output signal BL2 has a continuous voltage level. Further, each fourth signal portion SA4 may represent the portion of the second output signal BL2 during the associated second time period ZP2 without requiring the fourth signal portion SA4 to be identical to the represented portion of the second output signal BL2. In an example, the fourth signal portion SA4 may qualitatively represent the corresponding portion of the second output signal BL2. This may be caused, for example, by the second low-pass filter unit 148 and/or by the second DC component suppression unit 152. In an example, each fourth signal portion SA4 may represent a signal filtered portion of the second output signal BL2 during the corresponding second time period ZP2.

In an example, the second sampling unit 156 comprises a fifth series circuit extending from the input node 174 of the second sampling unit 156 to a reference potential, in particular the ground potential. The fifth series circuit includes a fifth switch unit S5 and a fifth capacitor C5. In an example, the control unit 122 is coupled to the fifth switch unit S5 via the fourth control signal line 144 so that the control unit 122 can control the fifth switch unit S5. Figure 3d illustrates an example of a control signal phi1 that can be generated by the control unit 122 to control the fifth switch unit S5. Preferably, the control signal phi1 is such that the fifth switch unit S5 is closed during every second time period ZP2. Furthermore, the control signal phi1 is preferably configured such that the fifth switch unit S5 is open during the remaining time. Therefore, in an example, the control signal phi1 may be transmitted from the control unit 122 to the fifth switch unit S5 such that the fifth switch unit S5 is closed exclusively during every second time period ZP2. In each second time period ZP2, the fifth capacitor C5 is charged by the portion of the second measurement signal BLF2 that is applied during the respective second time period ZP2. As a result, the fifth capacitor C5 is charged exclusively in each second time period ZP2 by a fourth signal portion SA4. In the other time periods, the fifth capacitor C5 is not charged. Therefore, the voltage across the fifth capacitor C5 represents an average of the voltages of the fourth signal sections SA4 that contributed to the charging of the fifth capacitor C5. Further, at a node 184 of the fifth series circuit between the fifth switch S5 and the fifth capacitor C5, a fourth average signal d2l representing an average of the voltage values from the fourth signal sections SA4 can be taken. Therefore, the second detector unit 134 is configured such that the second detector unit 134 generates a fourth average signal d2l from the fourth signal sections SA4. For this purpose, the second sampling unit 156 may be used. However, in principle, it is also possible that the second detector unit 134 comprises another unit or another embodiment to generate the fourth average signal d2l from the fourth signal sections SA4.

Provided that the second signal line 136, which may extend from the second output terminal 120 of the transmitter 100 to the second input terminal 166 of the receiver 104, is without fault, the fourth average signal d2l will represent an expectable and/or predictable voltage value. In Figure 3b, this voltage value is therefore represented by a dashed line representing a constant voltage level.

However, should a fault (not shown) occur in the second signal line 136, for example an interruption (not shown) in the second signal line 136, then this will affect the second average signal d2l.

The receiver 104 preferably comprises a second impedance Rtl2 which can act between the second input terminal 166 and a reference potential, in particular a ground potential. If the interruption in the second signal line 136 exists, this impedance Rtl2 no longer acts indirectly on the second output terminal 120. It follows that the second signal generation unit 114 generates a second output signal BL2 with a larger voltage swing and a second measurement signal BLF2 with a larger voltage swing (not shown in the figures), while being driven by the control unit 122.

In an example, the second sampling unit 156 includes a sixth series circuit extending from the input node 174 of the second sampling unit 156 to a reference potential, particularly the ground potential. The sixth series circuit includes a sixth switch unit S6 and a reference voltage source 186. In an example, the control unit 122 is coupled to the sixth switch unit S6 via the fourth control signal line 144 so that the control unit 122 can control the sixth switch unit S6. Each of figure 3e and 4e shows an example of the control signal phi3 that allows the control unit 122 to control the sixth switch unit S6. Preferably, the control signal phi3 is such that the sixth switch unit S6 is closed during every third time period ZP3. Furthermore, the control signal phi3 is preferably configured such that the sixth switch unit S6 is open during the remaining time. Therefore, in an example, the control signal phi3 may be transmitted from the control unit 122 to the sixth switch unit S6 such that the sixth switch unit S6 is closed exclusively during each third time period ZP3. In every third time period ZP3, the average value of the second measurement signal BLF2 is drawn to a voltage generated by the reference voltage source 186. As a result, the voltage swing of the second measurement signal BLF2 settles symmetrically around the average value of the second measurement signal BLF2. The correspondingly adjusted measurement signal BLF2 is shown in an example in Figure 3b.

The control signal phi1 for controlling the fifth switch unit S5 is again shown in Figure 4d. Due to the larger voltage swing of the second measurement signal BLF2 if the second signal line 136 is broken, the fifth switch unit S5 closed during the second time period SP2 will lead to a smaller charge of the fifth capacitor C2, so that the voltage across the fifth capacitor C5 decreases (not shown) with every second time period ZP2 or with every fourth signal section SA4. The voltage value of the fourth average signal d2l decreases (not shown) exclusively during every second time period ZP2 or exclusively with every fourth signal section SA4. Therefore, from this decrease in the voltage value of the fourth average signal d2l, it can also be inferred that there is an interruption (not shown) in the second signal line 136.

However, the interruption in the second signal line 136 in the aforementioned example may also be inferred from the difference between the voltage value of the third average signal d1l and the voltage value of the fourth average signal d2l. This is because, with the interruption of the second signal line 136, the difference between the third average signal d1l and the fourth average signal d2h increases significantly. The difference is dependent on and/or even proportional to the electrical impedance, in particular the electrical resistance, experienced or seen by the transmitter 100 between the output terminals 112, 120 through the signal lines 126, 136 and the internal impedances, in particular internal resistances of the receiver 104. If an interruption occurs as a fault in the second signal line 136, said impedance increases, so that the difference also increases. If a short circuit occurs as a fault between the signal lines 126, 136, the impedance decreases and consequently the difference also decreases.

In an example, the control unit 122 is configured to detect the second fault on the second signal line 136 based on the third average signal d1l and the fourth average signal d2l. In an example, the node 182 is coupled to the control unit 122 (not shown). The control unit 122 may be configured to evaluate the third average signal d1l and the fourth average signal d2l. Further, the control unit 122 may be configured to determine whether the second fault exists on the second signal line 136 based on the result of the evaluation.

In an example, the control unit 122 is configured to detect the second fault on the second signal line 136 based on the difference between the third average signal d1l and the fourth average signal d2l. The difference may also be referred to as the second difference. Preferably, the second difference refers to the actual difference between the actual value of the third average signal d1l and the actual value of the fourth average signal d2l.

In an example, the control unit 122 is configured to compare the second difference to a second reference value. The second reference value may be a predefined value. For example, the second reference value may be recorded during fault-free operation. During operation of the transmitter 100, the control unit 122 may use the stored first reference value to compare the currently detected second difference to the second reference value. In an example, the control unit 122 is configured to detect the second fault in the second signal line 136 based on the comparison result. For example, if the control unit 122 determines that the second difference is (significantly) larger or (significantly) smaller than the second reference value, the corresponding difference may indicate a fault in the second signal line 136.

In an example, the control unit 122 is configured to detect the second fault in the second signal line 136 as a short circuit between the first signal line 126 and the second signal line 136 if the second difference is less than the second reference value by more than a third threshold value. As has been previously explained, the value of the second difference decreases if a short circuit occurs between the first signal line 126 and the second signal line 136. If the second difference is less than the third reference value, this indicates a short circuit between the first and second signal lines 126, 136. The third threshold value may be a predefined value. Furthermore, the third threshold value may be stored by the control unit 122. The third threshold value prevents small changes in the second difference, such as those caused by noise, from resulting in false positive fault detection. The third threshold value therefore helps to ensure that the second fault can be detected by means of the transmitter 100 in a manner that is robust to disturbance.

It has been found that the second difference becomes smaller if, for example, the second signal line 136 receives a short circuit to a reference potential, such as the ground potential. In an example, the control unit 122 is therefore configured to detect the second fault in the second signal line 136 as a short circuit between the second signal line 136 and a reference potential, in particular a ground potential, if the second difference is smaller than the third reference value by more than a fourth threshold value. The fourth threshold value may be a predefined value. Preferably, the fourth threshold value is greater than the third threshold value. This makes it possible to distinguish whether there is a short circuit between the two signal lines 126, 136 or a short circuit of the second signal line 136 to the reference potential, in particular the ground potential.

In an example, the control unit 122 is configured to detect the second fault in the first signal line 136 as an interruption in the second signal line 136 if the second difference is greater than the third threshold value by more than the third reference value. The interruption may also be referred to as an open wire. The third threshold value prevents small changes in the second difference, such as those caused by noise, from resulting in false positive fault detection. The third threshold value therefore helps to ensure that an interruption in the second signal line 136 can be detected as the third fault by means of the transmitter 100, even robustly in the face of disturbance.

In an example, the control unit 122 is configured to detect a second trajectory of the second difference over time and a first change per unit time in the second trajectory. Further, the control unit 122 may be configured to compare the second change per unit time with a second deviation value. The second deviation value may be a predefined value. The control unit 122 may be configured to detect the second fault in the second signal line 136 based on the result of the comparison. In an example, the control unit 122 may be configured to detect the second fault in the second signal line 136 if the value of the first difference per unit time is greater than the second deviation value. If the value of change in the second difference per unit time is greater than the second deviation value, it may be assumed that there is an unusually rapid change in the second difference and such change is caused by a fault in the second signal line 136. Preferably, the unit time is at least 10ms so that high frequency noise can be prevented from causing false positive fault detection. Furthermore, the unit of time is preferably less than 500ms to ensure fast fault detection.

In an example, the control unit 122 is configured to detect a second duration while the second change per unit time is continuously greater than the second deviation value, and wherein the control unit 122 is preferably configured to detect the second fault in the second signal line based on the second duration. In an example, the second fault in the second signal line 136 is positively detected by the control unit 122 only if the second duration is greater than a predefined first time. Short very large changes in the second difference, such as may be caused by disturbance, are thus not considered faults.

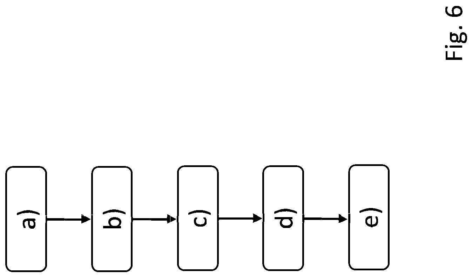

Fig. 6 shows a simplified flow chart of a method for a transmitter according to the present disclosure. The transmitter 100 is configured to transmit a message to a receiver 104. The transmitter 100 comprising a first signal generating unit 106 with a first internal impedance 108 and a first signal interface 110 coupled to a first output terminal 112 of the transmitter 100, the transmitter 100 further comprising a second signal generating unit 114 with a second internal impedance 116 and a second signal interface 118 coupled to a second output terminal 120 of the transmitter 100, the transmitter 100 further comprising a control unit 122 and a first detector unit 124 coupled to the first output terminal 112 adapted to be coupled to the receiver 104 via a first signal line 126, wherein the message comprises a plurality of symbols 128, each symbol comprising a first symbol part 130 and second symbol part 132, and wherein the method comprises the steps of:
a) controlling the first and second signal generating units 106, 114 with the control unit 122 to transmit each first symbol part 130 so that, for each first symbol part 130, a first internal voltage is generated by the first signal generating unit 106 and a second internal voltage is generated by the second signal generating unit 114 over a respective associated first time period ZP1, wherein a predefined first voltage difference SD1 is between the first internal voltage and the second internal voltage,
b) detecting a first output signal at the first output terminal 112 via the first detector unit 124,
c) controlling the first detector unit 124 by the control unit 122 such that the first detector unit 124 detects the first output signal in each first time period ZP1 as a first signal section SA1,
d) generating a first average signal d1h from the first signal sections SA1 by the first detector unit 124, and
e) detecting a fault on the first signal line 126 based on the first average signal d1h by the control unit 122.

Although the described exemplary embodiments disclosed herein focus on devices, systems, and methods for using same, the present disclosure is not necessarily limited to the example embodiments illustrate herein. For example, various embodiments of providing

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predefined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first", "second", "third", etc. are used to arbitrarily distinguish between the elements such terms describe. Thus, these terms are not necessarily intended to indicate temporal or other prioritization of such elements.

## Claims

1. A transmitter for transmitting a message to a receiver, comprising:
a first signal generating unit having a first internal impedance and a first signal interface coupled to a first output terminal of the transmitter,
a second signal generating unit having a second internal impedance and a second signal interface coupled to a second output terminal of the transmitter
a control unit, and
a first detector unit,
wherein the first detector unit is coupled to the first output terminal, which can be coupled to the receiver via a first signal line,
wherein the message comprises a plurality of symbols, each symbol comprising a first symbol part and a second symbol part,
wherein the control unit is configured to control the first and second signal generating units for transmitting each first symbol part such that, for each first symbol part, a first internal voltage is generated by the first signal generating unit over a respective associated first time period and a second internal voltage is generated by the second signal generating unit over the same first time period, wherein a predefined first voltage difference is between the first internal voltage and the second internal voltage,
wherein the first detector unit is configured to detect a first output signal at the first output terminal,
wherein the control unit is configured to control the first detector unit such that the first detector unit detects the first output signal in each first time period as a respective first signal section,
wherein the first detector unit is configured to generate a first average signal from the first signal sections, and
wherein the control unit is configured to detect a first fault on the first signal line based on the first average signal.

2. The transmitter of claim 1, wherein the control unit is configured to control the first and second signal generating units to transmit each second symbol part such that, for each second symbol part, the second internal voltage is generated by the first signal generating unit over a respective associated second time period and the first internal voltage is generated by the second signal generating unit over the same second time period, wherein the control unit is configured to control the first detector unit such that the first detector unit detects the first output signal in each second time period, respectively, as a second signal section, wherein the first detector unit is configured to generate a second average signal from the second signal sections, and wherein control unit is configured to detect the first fault on the first signal line based on the first average signal and the second average signal.

3. The transmitter of claim 2, wherein the control unit is configured to detect the first fault on the first signal line based on a first difference between the first average signal and the second average signal.

4. The transmitter of claim 3, wherein the control unit is configured to compare the first difference to a first reference value and, based on the comparison result, detect the first fault on the first signal line.

5. The transmitter of claim 4, wherein the control unit is configured to detect the first fault on the first signal line as a short circuit between the first and second signal lines if the first difference is smaller than the first reference value by more than a first threshold value.

6. The transmitter of claim 4 or 5, wherein the control unit is configured to detect the first fault on the first signal line as an open wire at the first signal line if the first difference is larger than the first reference value by more than the first threshold value.

7. The transmitter of any of the claims 1 to 6, wherein the transmitter comprises a second detector unit, wherein the second detector unit is coupled to the second output terminal, which can be coupled to the receiver via a second signal line, wherein the second detector unit is configured to detect a second output signal at the second output terminal, wherein the control unit is configured to control the second detector unit such that the second detector unit detects the second output signal in each first time period as a respective third signal section, wherein the second detector unit is configured to generate a third average signal from the third signal sections, and wherein the control unit is configured to detect a second fault on the second signal line based on the third average signal.

8. The transmitter of claim 7, wherein the control unit is configured to control the first and second signal generating units to transmit each second symbol part such that, for each second symbol part, the second internal voltage is generated by the first signal generating unit over a respective associated second time period and the first internal voltage is generated by the second signal generating unit over the same second time period, wherein the control unit is configured to control the second detector unit such that the second detector unit detects the second output signal in each second time period, respectively, as a fourth signal section, wherein the second detector unit is configured to generate a fourth average signal from the fourth signal sections, and wherein control unit is configured to detect the second fault on the second signal line based on the third average signal and the fourth average signal.

9. The transmitter of claim 8, wherein the control unit is configured to detect the second fault on the second signal line based on a second difference between the third average signal and the fourth average signal.

10. The transmitter of claim 9, wherein the control unit is configured to compare the second difference to a second reference value and, based on the comparison result, detect the second fault on the second signal line.

11. The transmitter of claim 10, wherein the control unit is configured to detect the second fault on the second signal line as a short circuit between the first and second signal lines if the second difference is smaller than the second reference value by more than a second threshold value.

12. The transmitter of claim 10 or 11, wherein the control unit is configured to detect the second fault on the second signal line as an open wire at the second signal line if the second difference is larger than the second reference value by more than the second threshold value.

13. The transmitter any of the claims 1 to 12, when depending on claim 7, wherein control unit is configured to detect a third fault on the one of the signal lines based on the first average signal and the third average signal.

14. The transmitter any of the claims 1 to 12, when depending on claims 2 and 8, wherein control unit is configured to detect a fourth fault on the one of the signal lines based on the second average signal and the fourth average signal.

15. A method for a transmitter to transmit a message to a receiver, the transmitter comprising a first signal generating unit with a first internal impedance and a first signal interface coupled to a first output terminal of the transmitter, the transmitter further comprising a second signal generating unit with a second internal impedance and a second signal interface coupled to a second output terminal of the transmitter, the transmitter further comprising a control unit and a first detector unit coupled to the first output terminal adapted to be coupled to the receiver via a first signal line, wherein the message comprises a plurality of symbols, each symbol comprising a first symbol part and second symbol part, and wherein the method comprises the steps of:
a) controlling the first and second signal generating units with the control unit to transmit each first symbol part so that, for each first symbol part, a first internal voltage is generated by the first signal generating unit and a second internal voltage is generated by the second signal generating unit over a respective associated first time period, wherein a predefined first voltage difference is between the first internal voltage and the second internal voltage,
b) detecting a first output signal at the first output terminal via the first detector unit,
c) controlling the first detector unit by the control unit such that the first detector unit detects the first output signal in each first time period as a first signal section,
d) generating a first average signal from the first signal sections by the first detector unit, and
e) detecting a fault on the first signal line based on the first average signal by the control unit.
